# EUROPEAN PATENT APPLICATION

(11) **EP 2 204 697 A2**
(43) Date of publication of application: **07.07.2010**
(21) Application number: 10161132.5
(22) Date of filing: 19.09.2003
(51) Int. Cl.: G03F 7/20, G03F 9/00

(54) **Marker structure, lithographic projection apparatus, method for substrate alignment using such a structure, and substrate comprising such marker structure**

(30) Priority: 20.09.2002 US 411861 P; 26.09.2002 US 413601 P; 01.04.2003 EP 03075954; 12.05.2003 EP 03076422
(62) Divisional of application: 03077976.3
(71) Applicant: ASML Netherlands B.V., 5504 DR Veldhoven (NL)
(72) Inventor: Van Haren, Richard, 5583 XM, Waalre (NL); Hinnen, Paul, 5506 AW, Veldhoven (NL); Lalbahadoersing, Sanjaysingh, 5709 KZ, Helmond (NL); Megens, Henricus, 5581 HD, Waalre (NL); Van der Schaar, Maurits, 5658 AK, Eindhoven (NL)
(74) Representative: Raukema, Age

(57) **Abstract**

Marker structure on a substrate for optical alignment of said substrate, said marker structure comprising a plurality of first structural elements and a plurality of second structural elements,
in use said marker structure allowing said optical alignment based upon
- providing at least one light beam directed on said marker structure,
- detecting light received from said marker structure at a sensor,
- determining alignment information from said detected light, said alignment information comprising information relating a position of said substrate to said sensor.

## Description

### Field of the invention

The present invention relates to a marker structure as defined in the preamble of claim 1, a lithographic projection apparatus comprising a device for wafer alignment which uses said marker structure, a method for wafer alignment using said marker structure, and a substrate comprising such a marker structure.

### Background of the invention

The present invention finds an application in the field of lithographic projection apparatus that encompass a radiation system for supplying a projection beam of radiation, a support structure for supporting patterning means, which serves to pattern the projection beam according to a desired pattern, a substrate table for holding a substrate; and, a projection system for projecting the patterned beam onto a target portion of the substrate.

The term "patterning means" as employed here should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmission mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a visco-elastic control layer and a reflective surface. The basic principle behind such an apparatus is that (for example) addressed areas of the reflective surface reflect incident light as diffracted light, whereas unaddressed areas reflect incident light as non-diffracted light. Using an appropriate filter, the said non-diffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described here above, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as set forth here above.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemical-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens".

Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

For a lithographic process an alignment of the wafer to be processed with the mask pattern on the mask should be as precise as possible for a correct definition of features on the substrate, which features all should have sizes within specified tolerances. To this end, the lithographic projection apparatus comprises a wafer alignment module which provides for alignment of the substrate with the mask and mask pattern within a given (specified) tolerance. The wafer alignment system typically performs the alignment based on optical means. The position of a wafer or a portion of a wafer is determined by measuring an optical response from an optical marker which is illuminated by an optical source: for example, a grating is illuminated by a laser beam, the laser beam diffracts from the grating, and one or more of the diffracted orders are measured by respective sensors, which are typically located on a reference plane. Using the output of the sensors the position of the wafer can be derived (relative to the reference plane).

In the prior art optical markers comprise a grating with a periodicity suitable for diffraction of impinging light with a wavelength well within the visible range of the spectrum. A typical periodicity is 16 µm. The grating is typically constructed of lines and trenches. Typically, the line width and trench width are each 8 µm. In order to obtain sufficient diffracted light from the grating and to obtain well-defined diffraction maxima and minima, the grating must encompass a minimal number of lines and intermediate trenches. The size in the direction of the periodic structure is about 750 µm.

The grating may be a phase grating or phase marker which takes into account a phase difference between the phase of rays scattered at the upper surface of the grating and the phase of rays scattered at the lower surface of the grating.

Also, the grating may be an amplitude grating which only takes into account the periodic structure of the grating without any further phase difference relating to an upper or lower level in the grating. Typically, an amplitude grating or amplitude marker is constructed of a periodic structure of first and second elements, which have similar surface levels but different respective reflectance.

Optical markers are used during microelectronic device processing (or IC processing) along the full manufacturing line. During the front end of line (FEOL), markers are used for alignment during manufacturing of transistor structures. At a later stage during the back end of line (BEOL), markers are needed for alignment of metallisation structures, e.g. connect lines, and vias. It is noted that in both cases the integrity of the markers must be sufficient to meet the required accuracy of alignment.

During semiconductor manufacturing processes a wafer is subjected to a plurality of treatments such as annealing, etching, polishing, etc., which may likely cause roughness of a marker (a recessed area in the marker and/or warping of the marker). Such marker roughness causes an alignment error of the image which may contribute to an overlay error in the construction of a semiconductor device. Also, it is conceivable that during the subsequent stages of processing the quality of markers tend to diminish.

A disadvantage of prior art optical markers is that during IC processing it is difficult to control the phase depth of the optical marker. As a result, the intensity of diffracted light under a given diffraction angle may be low and even close to zero, and accurate measurement of the diffracted beam may be difficult or even impossible. The phase depth can be defined as the resolved height difference between a top surface of a line and a top surface of a trench in a grating under a given angle of diffraction. If under an angle of diffraction, where (under optimal conditions) a maximum of diffracted intensity is expected, the phase depth equals half a wavelength of the applied radiation, interference between diffracted waves will result in a low or zero intensity.

Control of the phase depth during IC processing may be difficult due to process variations from wafer to wafer, and also across a single wafer.

A further disadvantage of prior art markers results from the dependence of marker properties as a function of the layer(s) below the marker. It is known that due to different optical behaviour of the various layers, as found in semiconductor devices, the contrast of the marker may vary, which results in variations of the diffracted intensity as function of the layer below.

Moreover, it is known that various processing steps may adversely influence the shape of alignment markers. Due to the effect on the shape, the alignment by such modified markers may comprise an error which can result from the fact that the modified shape of the marker changes the generated (pattern of) diffracted beams.

Furthermore, in the prior art, during BEOL processing, optical markers could be detected under capping layers by virtue of the residual structure which was visible at the surface. However, due to application of planarisation processes such as chemical mechanical polishing (CMP), the option to use a residual marker structure for alignment in many cases has become impossible.

In the prior art, markers on a semiconductor substrate that comprise trenches filled with tungsten, are subjected to a CMP process for removing tungsten from the surface and planarising the surface. Due to the CMP process the tungsten structures are either filled or underfilled. The extent of filling is related to the phase depth of an optical signal generated by the marker, i.e., two discrete phase depth levels exist. One level relates to filled tungsten structures which are shallow and have a small phase depth, the other level relates to underfilled tungsten structures which are relatively deep and have a large phase depth. Small phase depth of the filled markers is undesirable since the alignment error caused by the small phase depth is relatively large. Also, the large phase depth does not guarantee that the alignment error is reduced: the phase depth may be such that extinction of the optical signal results. Furthermore, no control over the phase depth is obtained.

The influence of optical markers on IC processing may lead to undesirable side effects due to the fact that the optical markers are inherently larger than feature sizes in integrated circuits. In the prior art the minimum feature size of markers is in the order of 1 µm. In current microelectronic devices, the typical minimal feature size is about 100 nm (depending on the device generation). Since the marker usually consists of the same material as (part of) the devices, the presence of an additional marker area of a substantial size in the vicinity of a device may have an influence on the local processing rate for that device in a given processing step. For example, a chemical reaction in a reactive ion etching process or a chemical deposition process may be influenced by the presence of a large marker area due to some kinetic constraint, or due to a local deviation of the wafer temperature, etc. A size difference between marker and device feature may thus lead, for example, to modification of a processing step for devices located closely to a marker. Due to the modification of the processing a variation of device characteristics may occur across a die and/or a wafer.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The person skilled in the art will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and " projection beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm).

### Summary of the invention

It is an object of the present invention to provide a marker structure that overcomes effects caused by a relatively large marker area on features of devices located in the vicinity of such a large marker area.

This object is achieved in a marker structure as defined in the preamble of claim 1, **characterised in that** said first structural element comprises a plurality of primary lines and a plurality of first interposed lines.

Advantageously, the structural elements that build the marker structure are each subdivided in sub-elements which have a characteristic size comparable to the product feature size. By mimicking the feature size of the product more closely, size-induced processing effects are minimised.

Moreover, it is an object of the present invention to provide a lithographic projection apparatus which allows application of the marker structure as described above.

Furthermore, it is an object of the present invention to provide a method of alignment of a substrate in a lithographic projection apparatus which uses the marker structure as described above.

### Brief description of drawings

Below, the invention will be explained with reference to some drawings, which are intended for illustration purposes only and not to limit the scope of protection as defined in the accompanying claims.
Figure 1 depicts a lithographic projection apparatus comprising at least one marker structure according to the present invention;
Figure 2 shows a planar view of a marker structure according to an embodiment of the present invention;
Figure 3 shows an application of a stack of markers in accordance with an embodiment of the present invention.

### Description of embodiments

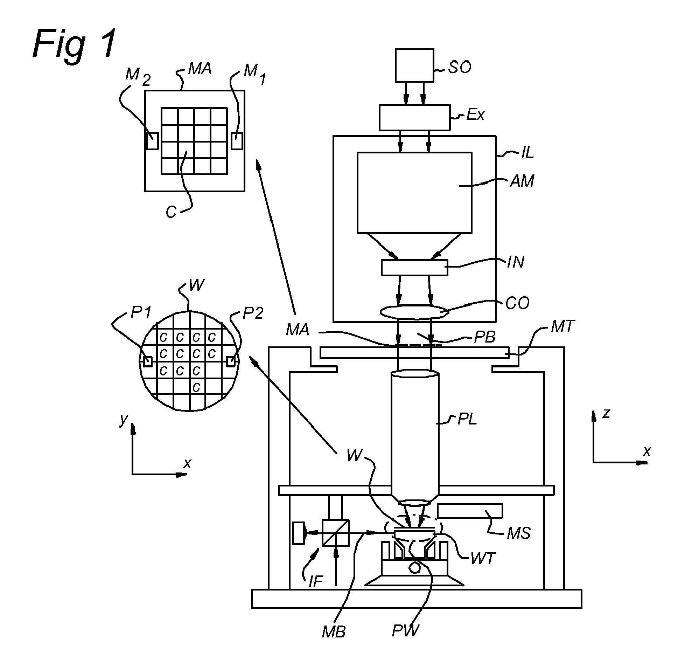

Figure 1 schematically depicts a lithographic projection apparatus 1 comprising at least one marker structure according to a particular embodiment of the invention. The apparatus comprises:
- a radiation system Ex, IL, for supplying a projection beam PB of radiation (e.g. UV radiation). In this particular case, the radiation system also comprises a radiation source SO;
- a first object table (mask table) MT provided with a mask holder for holding a mask MA (e.g. a reticle), and connected to first positioning means (not shown) for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source SO (e.g. a mercury lamp or an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source SO may be within the housing of the lithographic projection apparatus (as is often the case when the source SO is a mercury lamp, for example), but that it may also be remote from the lithographic projection apparatus, the radiation beam which it produces being led into the apparatus (e.g. with the aid of suitable directing mirrors); this latter scenario is often the case when the source SO is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW and interferometric measuring means, the substrate table WT can be moved accurately, e.g. so as to position different target portions C in the path of the beam PB. Similarly, the first positioning means (acting on mask table MT) can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the X and/or Y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the Y-direction) with a speed v, so that the projection beam PB is caused to scan over a mask image; concurrently, the substrate table WT is simultaneously moved in the same or opposite direction at a speed V = M v, in which M is the magnification of the lens PL (typically, M = 1/4 or 1/5). In this manner, a relatively large target portion C can be exposed, without having to compromise on resolution.

The interferometric measuring means typically can comprise a light source, such as a laser (not shown), and one or more interferometers for determining some information (e.g., position, alignment, etc.) regarding an object to be measured, such as a substrate or a stage. In Figure 1, for example, one interferometer IF is schematically depicted. The light source (laser) produces a metrology beam MB which is routed to the interferometer IF by one or more beam manipulators. In case more than one interferometer is present, the metrology beam is shared between them, by using optics that split the metrology beam in various separate beams for each interferometer.

A substrate alignment system MS for alignment of a substrate on table WT with the mask MA on mask table MT, is schematically shown at an exemplary location close to substrate table WT, and comprises at least one light source which generates a light beam aimed at a marker structure on the substrate and at least one sensor device which detects an optical signal from that marker structure. It is noted that the location of the substrate alignment system MS depends on design conditions which may vary with the actual type of lithographic projection apparatus. The marker structures may be for example substrate alignment marks P1, P2.

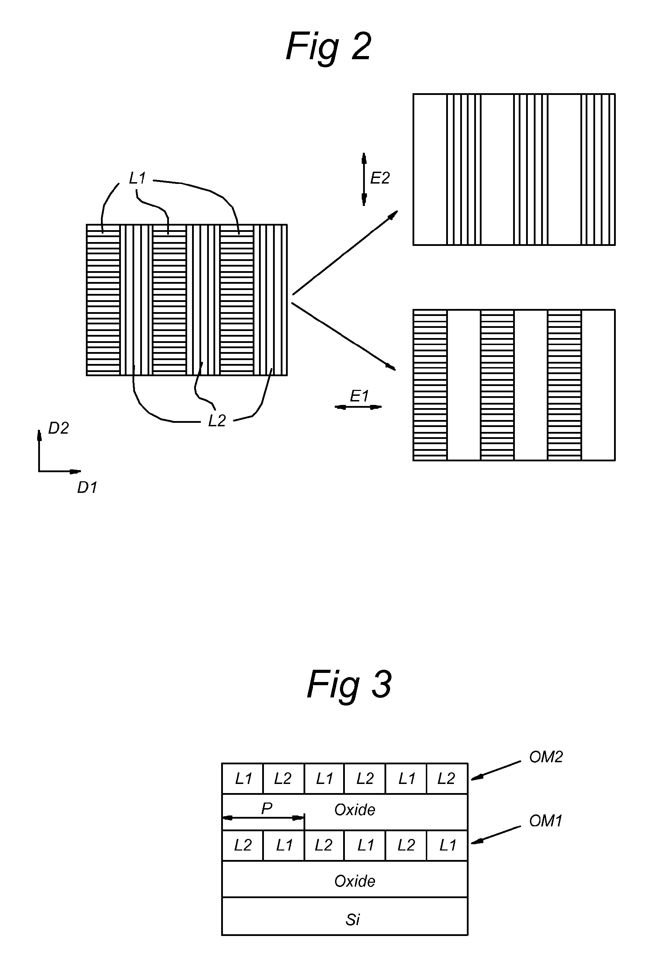

Figure 2 shows a planar view of a marker structure according to an embodiment of the present invention.

In this embodiment of the present invention the first structural elements are sub-segmented in a plurality of primary lines L1 extending in a first direction D 1, each primary line having a width comparable to critical feature sizes of a device. In between the primary lines are interposed lines of a different material. The width of the primary and interposed lines is such that dense device structures with critical feature sizes are mimicked.

Further, the second structural elements in between the first structural elements are sub-segmented in a plurality of secondary lines L2 extending in a second direction D2, with interposed lines of a different material in between. Again, the secondary lines and interposed lines have widths comparable to dense device structures with the critical feature sizes for devices.

The second direction D2 is perpendicular to the first direction D1.

The material of the primary lines L1 and the secondary lines L2 is typically the same, e.g., a metal, while the material in between the primary lines L1 and in between the secondary lines L2 may be a dielectric or semiconductor.

In the sub-segmentation the original periodicity P of the marker structure is maintained to allow the application of the alignment sensors from the prior art.

It is further noted that the width of the primary line L1 may or may not be equal to the width of a secondary line L2.

The alignment system uses a first laser beam with a first linear polarisation E1 and a second laser beam with a second linear polarisation E2. The wavelength of the first laser beam differs from the wavelength of the second laser beam. For example, the first laser beam consists of red light, and the second laser beam of green light.

The first linear polarisation direction E1 is perpendicular to the second linear polarisation direction E2. Further, the first linear polarisation E1 is arranged in such a way that the line segments L1 in the marker lines allow a further transmission of the first polarised light beam in order to form a diffraction pattern of the marker structure. Similarly, the second linear polarisation E2 is arranged in such a way that the line segments L2 in the intermediate marker elements allow a further transmission of the second polarised light beam to form a diffraction pattern of the marker structure.

Figure 3 shows an application of a stack of markers in accordance with the embodiment of the present invention. A further advantage of the structure of this embodiment is the fact that at least two of such markers can be stacked on top of each other, without causing any interference between them. By stacking marker structures in subsequent layers, the needed estate for the marker structures in the scribelane can be significantly reduced. In the example of Figure 3 in such a stack, a second marker OM2 is translated over half the periodicity P with respect to the first marker OM1, with the width of "lines" being equal to the width of "trenches". Due to the segmentation of the "trenches" and "lines" perpendicular to each other, the polarisation effect prohibits cross-talk between the upper and lower marker structure. When using the first and second laser beams with their mutual perpendicular polarisation, the lower marker structure appears covered by the upper marker: the alignment system only detects the upper marker structure.

## Claims

1. Marker structure on a substrate for optical alignment of said substrate, said marker structure comprising a plurality of first structural elements and a plurality of second structural elements,
in use said marker structure allowing said optical alignment based upon
- providing at least one light beam directed on said marker structure,
- detecting light received from said marker structure at a sensor,
- determining alignment information from said detected light, said alignment information comprising information relating a position of said substrate to said sensor;
said marker structure being further **characterised in that,**
said first structural element comprises a plurality of primary lines and a plurality of first interposed lines.

2. Marker structure according to claim 1, wherein said first and said second structural elements are arranged to form a diffraction grating.

3. Marker structure according to claim 1 or claim 2, wherein said primary line comprises a first material and said first interposed line comprises a second material.

4. Marker structure according to claim 2 or any claim dependent thereon, wherein said plurality of first interposed lines form a periodic structure.

5. Marker structure according to claim 4, wherein the periodic structure extends in a direction substantially perpendicular to the periodic direction of the diffraction grating.

6. Marker structure according to claim 4, wherein the periodic structure extends in a direction substantially parallel to the periodic direction of the diffraction grating.

7. Marker structure according to claim 5 or 6, wherein
said second structural element comprises a plurality of secondary lines and a plurality of second interposed lines,
said plurality of second interposed lines forming a further periodic structure in a direction substantially perpendicular to the direction of the periodic structure formed by the plurality of first interposed lines.

8. Marker structure according to any of the claims 1 to 7, wherein said primary lines and said first interposed lines have a dimension comparable to a critical feature size of a product device being created on said substrate.

9. Marker structure according to claim 8, wherein said secondary lines and said second interposed lines have a dimension comparable to a critical feature size of a product device being created on said substrate.

10. An alignment method for aligning to the marker structure according to any one of claims 1-4, said method comprising
- providing at least one light beam directed on said marker structure,
- detecting light received from said marker structure at a sensor,
- determining alignment information from said detected light, said alignment information comprising information relating a position of said substrate to said sensor;
wherein said at least one light beam has a linear polarisation (E2) extending substantially perpendicular to the direction of the periodic structure formed by the plurality of first interposed lines, or said sensor has a polarisation filter which allows transmission of light having that linear polarisation (E2).

11. An alignment method for aligning to the marker structure according to any one of claims 1-4, said method comprising
- providing at least one light beam directed on said marker structure,
- detecting light received from said marker structure at a sensor,
- determining alignment information from said detected light, said alignment information comprising information relating a position of said substrate to said sensor;
wherein said at least one light beam has a linear polarisation (E1) extending substantially parallel to the direction of the periodic structure formed by the plurality of first interposed lines, or said sensor has a polarisation filter which allows transmission of light having that linear polarisation (E1).

12. An alignment method according to claims 10 and 11, wherein two light beams are directed on said marker structure, said light beams having substantially orthogonal linear polarisations (E1, E2) and being separately received.

13. A substrate for microelectronic devices comprising at least one marker structure according to any one of the preceding claims 1 - 12.

14. A lithographic projection apparatus comprising:
- a radiation system for providing a projection beam of radiation;
- a support structure for supporting patterning means, the patterning means serving to pattern the projection beam according to a desired pattern;
- a substrate table (WS) for holding a substrate;
- a projection system for projecting the patterned beam onto a target portion of the substrate;
- a substrate alignment system (MS) for detecting a position of said substrate relative to a position of said patterning means;
- said substrate comprising at least one marker structure according to any one of the claims 1 - 12.

15. Method of alignment of a substrate in a lithographic projection apparatus comprising:
- a radiation system for providing a projection beam of radiation;
- a support structure for supporting patterning means, the patterning means serving to pattern the projection beam according to a desired pattern;
- a substrate table (WS) for holding a substrate;
- a projection system for projecting the patterned beam onto a target portion of the substrate;
- a substrate alignment system (MS) for detecting a position of said substrate relative to a position of said patterning means;
said method comprising:
- providing at least one light beam directed on a marker structure according to any one of the claims 1 - 12;
- detecting light received from said marker structure at a sensor; and
- determining alignment information from said measurement, said alignment information comprising information relating a position of said substrate to said sensor.
